# EUROPEAN PATENT APPLICATION

(11) **EP 4 791 133 A1**
(43) Date of publication of application: **12.08.2026**
(21) Application number: 26155675.7
(22) Date of filing: 02.02.2026
(51) Int. Cl.: H05K 7/20

(54) **SYSTEM AND METHODS FOR IMMERSION SEMICONDUCTOR PACKAGE COOLING**

(30) Priority: 11.02.2025 US 202563757304 P; 29.08.2025 US 202519315472
(71) Applicant: Samsung Electronics Co., Ltd., Suwon-si, Gyeonggi-do 16677 (KR)
(72) Inventor: GAO, Hongxia, San Jose, CA 95134 (US); KIM, WooPoung, San Jose, CA 95134 (US)
(74) Representative: Kuhnen & Wacker Patent- und Rechtsanwaltsbüro PartG mbB

(57) **Abstract**

Disclosed herein are methods, devices and systems including a supporting board (110) and a first cooling structure (102) on the supporting board (110), the first cooling structure (102) including a first high-power density package immersed within a first dielectric fluid (106), the first dielectric fluid (106) thermally coupled to the first high-power density package. A first connector (108) is arranged between the first cooling structure (102) and the supporting board (110) and communicatively couples the first high-power density package to the supporting board (110). The first dielectric fluid (106) is separated from the first connector (108) by at least one surface of the first cooling structure (102). The first dielectric fluid may have a first liquid phase and a first vapor phase within the first cooling structure (102).

## Description

### TECHNICAL FIELD

The subject matter disclosed herein relates to microelectronics and integrated circuit (IC) structures. More particularly, the subject matter disclosed herein relates to a semiconductor structure involving a heat transfer mechanism.

### BACKGROUND

Semiconductor devices may be created using complex structures made up of sets of smaller components referred to as packages. Packaging describes the general method for connecting and integrating multiple computational components together in an integrated unit and may involve multiple different types of integrated circuits on multiple substrates which may combine into a single unit. Packaging may also describe a method for which multiple computational components within a single unit are protected by the use of various techniques to provide thermal, physical and electrical protection. However, cooling structure components face a number of challenges. For example, to increase capacity in computer such as a server, the ability to transfer heat needs to be increased. This may present challenges in the fabrication process.

It is further noted that background concepts discussed herein are for informational purposes only and are not intended to limit the present disclosure, nor should the background or field described be intended to limit the disclosure herein to a particular use or concept.

### SUMMARY

An example embodiment provides a device with a supporting board and a first cooling structure on the supporting board, the first cooling structure including a first high-power density package immersed within a first dielectric fluid, the first dielectric fluid thermally coupled to the first high-power density package. A first connector may be arranged between the first cooling structure and the supporting board and may communicatively couple the first high-power density package to the supporting board. The first dielectric fluid may be separated from the first connector by at least one surface of the first cooling structure. The first dielectric fluid may have a first liquid phase and a first vapor phase within the first cooling structure. A second cooling structure may be on the supporting board and include a second high-power density package immersed within a second dielectric fluid; the second dielectric thermally coupled to the second high-power density package. A second connector may be arranged between the second cooling structure and the supporting board with the second connector communicatively coupling the second high-power density package to the supporting board. The second dielectric fluid may be separated from the second connector by at least one surface of the second cooling structure. The first high-power density package may include at least one of a memory device and processing device. The first dielectric fluid may circulate in a closed loop from the first cooling structure to a first cooling device, and the first cooling device may include one or more of a thermoelectric cooler, a cold plate, a heat exchanger, a radiative fin, or a heat sink. A first supporter may be arranged between the first connector and the first high-power density package, the first supporter may also be between a surface of the first cooling structure and the first high-power density package, and the first supporter may contact the first dielectric fluid. One or more cooling devices may be mounted on an exterior surface of the first cooling structure, and may include one or more of a thermoelectric cooler, a cold plate, a heat exchanger, a radiative fin, and a heat sink.

An example embodiment provides a device with a supporting board and a first cooling structure on the supporting board, the first cooling structure including a first high-power density package immersed within a first dielectric fluid, the first dielectric fluid thermally coupled to the first high-power density package. A first connector may be arranged between the first cooling structure and the supporting board and communicatively couple the first high-power density package to the supporting board. A first cooling loop may circulate the first dielectric fluid to fluidically couple a first cooling device to a first inlet of the first cooling structure and the first cooling loop may fluidically couple a first outlet of the first cooling structure to the first cooling device. The first cooling device may include one or more of a thermoelectric cooler, a cold plate, a heat exchanger, a radiative fin, or a heat sink. One or more cooling devices may be mounted on an exterior surface of the first cooling structure and may include one or more of a thermoelectric cooler, a cold plate, a heat exchanger, a radiative fin or a heat sink. The first high-power density package may include at least one of a memory device and a processing device. A second cooling structure may be on the supporting board, the second cooling structure including a second high-power density package immersed within a second dielectric fluid, the first dielectric thermally coupled to the second high-power density package. A second connector may be arranged between the second cooling structure and the supporting board and communicatively couple the second high-power density package to the supporting board. A second cooling loop may circulate the second dielectric fluid to fluidically couple a second cooling device to a second inlet of the second cooling structure and the second cooling loop may fluidically couple a second outlet of the second cooling structure to the second cooling device. A first supporter may be arranged between the first connector and the first high-power density package and may be arranged between a surface of the first cooling structure and the first high-power density package, and the first supporter may contact the first dielectric fluid.

An example embodiment provides a system including a supporting board with a first cooling structure and a second cooling structure. The first cooling structure may include a first high-power density package immersed within a first dielectric fluid, the first dielectric fluid thermally coupled to the first high-power density package, and the first high-power density package may be communicatively coupled to the supporting board. The second cooling structure may include a second high-power density package immersed within a second dielectric fluid, the second dielectric fluid thermally coupled to the first high-power density package, and the first high-power density package may be communicatively coupled to the supporting board. A first cooling loop may circulate the first dielectric fluid to fluidically couple a first cooling device to a first inlet of the first cooling structure and the first cooling loop may fluidically couple a first outlet of the first cooling structure to the first cooling device. A second cooling loop may circulate the second dielectric fluid. The first high-power density package may include at least one of a memory device and a processing device. The supporting board, the first cooling structure, and the second cooling structure may be immersed within a liquid coolant in an immersion bath. The second cooling loop may fluidically couple a second cooling device to a second inlet of the second cooling structure and the second cooling loop may fluidically couple a second outlet of the second cooling structure to the second cooling device. The second cooling loop may fluidically couple the first cooling device to a second inlet of the second cooling structure, and the second cooling loop may fluidically couple a second outlet of the second cooling structure to the first cooling device. One or more first cooling devices may be mounted on an exterior surface of the first cooling structure, and may include one or more of a thermoelectric cooler, a cold plate, a heat exchanger, a radiative fin, and a heat sink. One or more second cooling devices may be mounted on an exterior surface of the second cooling structure, and may include one or more of a thermoelectric cooler, a cold plate, a heat exchanger, a radiative fin, and a heat sink. The second cooling loop may fluidically couple the first cooling structure to a second inlet of the second cooling structure and the second cooling loop may fluidically couple a second outlet of the second cooling structure to the first cooling device.

### BRIEF DESCRIPTION OF THE DRAWING

In the following section, the aspects of the subject matter disclosed herein will be described with reference to example embodiments illustrated in the figures, in which:
FIG. 1 depicts a cross-sectional view of a semiconductor structure of two cooling structures for high-power package devices on a shared board according to various embodiments of the subject matter disclosed herein;
FIG. 2 depicts a perspective view of a semiconductor structure of two cooling structures for high-power package devices on a shared board according to various embodiments of the subject matter disclosed herein;
FIG. 3 depicts a perspective view of a cooling surface structure for a cooling structure with a two-phase dielectric fluid cooling a high-power package device according to various embodiments of the subject matter disclosed herein;
FIG. 4 depicts a perspective view of a semiconductor structure for a cooling loop for a cooling structure cooling a high-power package device according to various embodiments of the subject matter disclosed herein;
FIG. 5 depicts a perspective view of a semiconductor structure for cooling loop for a cooling structure cooling a high-power package device having an additional surface cooler according to various embodiments of the subject matter disclosed herein;
FIG. 6 depicts a plan view of a semiconductor structure of two cooling loops for two cooling structures according to various embodiments of the subject matter disclosed herein;
FIG. 7 depicts a plan view of a semiconductor structure of parallel cooling loops for two cooling structures according to various embodiments of the subject matter disclosed herein;
FIG. 8 depicts a plan view of a semiconductor structure of a serial cooling loop for two cooling structures according to various embodiments of the subject matter disclosed herein;
FIG. 9 depicts a perspective view of a semiconductor structure of two cooling structures for high-power package devices on a shared board within an immersion bath according to various embodiments of the subject matter disclosed herein;
FIG. 10 depicts a plan view of a semiconductor structure of two cooling structures for high-power package devices on a shared board with and without the use of supporters according to various embodiments of the subject matter disclosed herein;
FIG. 11 depicts a perspective view of a semiconductor structure of two cooling structures for high-power package devices on a shared board with and without the use of supporters according to various embodiments of the subject matter disclosed herein; and
FIG. 12 depicts a flow chart demonstrating a method of creating a cooling structure according to various embodiments of the subject matter disclosed herein.

### DETAILED DESCRIPTION

In the following detailed description, numerous specific details are set forth in order to provide a thorough understanding of the disclosure. It will be understood, however, by those skilled in the art that the disclosed aspects may be practiced without these specific details. In other instances, well-known methods, procedures, components and circuits have not been described in detail to not obscure the subject matter disclosed herein.

Reference throughout this specification to "one embodiment" or "an embodiment" means that a particular feature, structure, or characteristic described in connection with the embodiment may be included in at least one embodiment disclosed herein. Thus, the appearances of the phrases "in one embodiment" or "in an embodiment" or "according to one embodiment" (or other phrases having similar import) in various places throughout this specification may not necessarily all be referring to the same embodiment. Furthermore, the particular features, structures or characteristics may be combined in any suitable manner in one or more embodiments. In this regard, as used herein, the word "exemplary" means "serving as an example, instance, or illustration." Any embodiment described herein as "exemplary" is not to be construed as necessarily preferred or advantageous over other embodiments. Additionally, the particular features, structures, or characteristics may be combined in any suitable manner in one or more embodiments. Also, depending on the context of discussion herein, a singular term may include the corresponding plural forms, and a plural term may include the corresponding singular form. Similarly, a hyphenated term (e.g., "two-dimensional," "pre-determined," etc.) may be occasionally interchangeably used with a corresponding non-hyphenated version (e.g., "two dimensional," "predetermined, etc.), and a capitalized entry (e.g., "Counter Clockwise," "Three-Dimensional," etc.) may be interchangeably used with a corresponding non-capitalized version (e.g., "counter clockwise," "three-dimensional," etc.). Such occasional interchangeable uses shall not be considered inconsistent with each other.

Also, depending on the context of discussion herein, a singular term may include the corresponding plural forms, and a plural term may include the corresponding singular form. It is further noted that various figures (including component diagrams) shown and discussed herein are for illustrative purpose only and are not drawn to scale. For example, the dimensions of some of the elements may be exaggerated relative to other elements for clarity. Further, if considered appropriate, reference numerals have been repeated among the figures to indicate corresponding and/or analogous elements.

The terminology used herein is for the purpose of describing some example embodiments only and is not intended to be limiting of the claimed subject matter. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

It will be understood that when an element or layer is referred to as being on, "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numerals refer to like elements throughout. As used herein, the term "and/or" includes any and all combinations of one or more of the associated listed items.

The terms "first," "second," etc., as used herein, are used as labels for nouns that they precede, and do not imply any type of ordering (e.g., spatial, temporal, logical, etc.) unless explicitly defined as such. Furthermore, the same reference numerals may be used across two or more figures to refer to parts, components, blocks, circuits, units, or modules having the same or similar functionality. Such usage is, however, for simplicity of illustration and ease of discussion only; it does not imply that the construction or architectural details of such components or units are the same across all embodiments or such commonly-referenced parts/modules are the only way to implement some of the example embodiments disclosed herein.

The term "surround" (as in "a first object surrounds a second object") as used herein describes the first object enclosing or is formed around or over the second object, or the first object accommodates, conforms, follows, aligns, or follows the path of the second object.

Unless otherwise defined, all terms (including technical and scientific terms) used herein have the same meaning as commonly understood by one of ordinary skill in the art to which this subject matter belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

As used herein, compute devices may refer to a wide variety of integrated circuits using electrical components. In some embodiments, compute devices may include central processing units (CPUs), logic chips, memory such as static random-access memory (SRAM), dynamic random-access memory (DRAM), synchronous dynamic random-access memory (SDRAM), double data rate DRAM or DDR DRAM, application processors (AP), auxiliary processing units (XPUs), graphical processing units (GPUs),, artificial intelligence (AI) chips, high bandwidth memory (HBM), and other application-specific integrated circuits (ASIC). In some embodiments, a combination of circuits may be present on a substrate. In some embodiments, compute devices may be referred to in terms such as microchips, microcontrollers, silicon chips. As used herein, an XPU may refer to an auxiliary processing unit designed to perform specialized or dedicated processing optimized for conducting specific tasks more efficiently than a general processing unit such as a CPU and may be also referred to as a data processing unit (DPU), infrastructure processing unit (IPU), function accelerator card (FAC), or network attached processing unit (NAPU).

As used herein substrates may refer to a variety of materials and structures, including wafers using silicon, wafers using silicon on an insulator (SOI) such as glass, wafers of other semiconductor materials such as germanium, as well as other semiconductor materials on an insulator. In some embodiments, a substrate may include an organic material. In some embodiments, the substrates may be referred to as wafers, dies, and chips alone or in combination. Bonding substrates may be thus known in some embodiments as die-to-die (D2D) bonding, wafer-to-wafer bonding (W2W) or die-to-wafer bonding (D2W). In some embodiments, a packaged chip may contain multiple substrates.

As used herein packaging refers to a process of forming interconnections between substrates. In some embodiments, the interconnections may be between direct surfaces and involve W2W, D2D, and D2W bonding. In other embodiments, techniques including wire bonding and other forms of indirect bonding may be performed alone or in combination with W2W, D2D, and D2W bonding. In some embodiments, circuits may be bonded directly facing each other, while in other embodiments a flip-chip bonding may be used. In some embodiments, interconnections may be made between substrates on a front or circuit side of the substrate.

As used herein, dielectric fluids refer to dielectric materials in liquid and/or vapor form. Dielectric materials are materials that have a low relative permittivity or a low dielectric constant, and thus function as an electrically non-conductive material. Dielectric fluids may maintain that state in liquid or vapor form. A multi-phase dielectric fluid may act as a dielectric material in both liquid and vapor form. Example dielectric fluids may include mineral oils, synthetic esters, silicone fluids, fluorinated liquids, hydrocarbon oils, as well as any other suitable fluid, as this list is not intended to be exhaustive.

Disclosed herein are various embodiments of devices, systems and methods related to immersion cooling of a heat producing computing package using a dielectric fluid. A heat producing computing package may include a number of compute devices and other integrated circuits on a shared substrate and may include a stack of compute devices in a form such as HBM, a GPU, as well as three-dimensional memory and other complex packaged semiconductors in a small volume. Such a heat producing package may be suitable for high complexity computing purposes such as Al, graphical rendering, large scale computational modeling, etc. where density of compute devices and supporting circuits provide a performance increase, for example, by reducing distances for signals to travel between memory units and processing units. A denser packaging structure of components such as processing units, however, may produce a larger amount of heat across a smaller surface area, which may provide a decrease in the performance of denser packaging. Immersion cooling with a dielectric fluid provides a means of cooling high-density computing packages enabling increased performance.

A dielectric fluid may be any suitable fluid or mix of fluids having a high thermal conductivity, good compatibility with the materials of the high-power density packages and provides electrical insulation between the high-power density package and the surrounding environment. For example, a dielectric fluid may include one or more mineral oils, synthetic esters, silicone fluids, fluorinated liquids, hydrocarbon oils, as well as any other suitable fluid. The dielectric fluid may provide increased thermal conductivity compared to the thermal conductivity of air or vacuum. The dielectric fluid may have good material compatibility with the materials of the high-power density package such as with respect to preventing corrosion, avoiding dissolving of packaging materials such as molding compounds, avoiding damage of the packaging materials, as well as avoiding buildup of deposits on the packaging by the dielectric fluid, or reactions with either the packaging material or materials the dielectric fluid may encounter within a cooling loop. The dielectric fluid may take the form of a dielectric material and act as an electric insulator such that an electrical current from the high-power density package is not transmitted via the dielectric fluid to a surrounding environment.

A high-power density package is a package having one or more electrical components including compute devices including processing devices and memory devices, as well as supporting circuitry, and may take the form of a chiplet, individual IC chips such as CPUs, GPUs, NPUs, and advanced packages such as HBM, as well as three-dimensional structures such device stacks where a combination of devices may be formed into a larger stack of devices. A package may be a high-power density package when the power consumption of the package exceeds a threshold such that the one or more component devices may exceed their operating temperature when running on a standard board. The threshold may vary by device and package, and a package may be limited by the sensitivity of the lowest device on the package. For example, in some embodiments, a high-power density package may produce 1 W, 10 W, 100 W, 1 kW, 2 kW or more of heat, although in other embodiments the threshold for a high-power density package may be lower or higher.

The dielectric fluid may surround the high-power density package within a cooling structure. The cooling structure may be a three-dimensional solid structure such as a box, cube, prism, cylinder, or other suitable three-dimensional shape. The cooling structure may also be referred to as a cooling box, although it should be understood that the cooling structure is not limited to the shape of a box. The cooling structure may have a bottom side, which may rest on a connector structure, the connector structure providing routing for power and communication signals between the high-power density package and a supporting board. The supporting board may be a printed circuit board (PCB) or take the form of a card such as a graphics card and may host multiple high-power density packages in individual cooling structures which may route power and communications signals via the supporting board. The cooling structure may have a fixed volume, such that the volume of the cooling structure remains approximately constant over the operating range, for example, an operating temperature range.

The dielectric fluid may circulate within the cooling structure, as well as may be circulated between the cooling structure and an external cooling system. The dielectric fluid may enter the cooling structure via an inlet and exit the cooling structure via an outlet. When multiple cooling structures are used on the same supporting board, each cooling structure may have individual inlets and outlets. The dielectric fluid may be circulated either actively or passively. Active circulation uses a mechanism such as a pump, fan, impeller, compressor, expander or other circulation means using power to circulate the fluid. Alternatively, the dielectric may be circulated using passive means, for example a cooling loop may allow vapor to travel upwards to a radiator where vapor condenses and is returned to the inlet via gravity.

The high-power density package may be mounted on a supporter. The supporter may provide both physical support for the high-power density package, as well as provide one or more coupling channels for power and communication signals between the high-power density package and the connector. The supporter may take the form of any suitable structure and may include one or more structural supports as well as one or more vias to allow dielectric fluid to contact the high-power density package from below.

The dielectric fluid may take the form of a multi-phase dielectric fluid and may include a vapor phase and a liquid phase within the cooling structure separated by a phase boundary, which may be the surface of the liquid phase. The high-power density package may be immersed within the liquid phase of the multi-phase dielectric fluid, such that the top and sides of the high-power density package may be fully in contact with the liquid phase, and at least a portion of the bottom of the high-power density package may contact the liquid phase depending on the structure of the supporter.

As the high-power density package may have most of its surface area in contact with the dielectric fluid, heat produced by the high-power density package may be transferred to the dielectric fluid. The dielectric fluid may have a higher specific heat capacity than air or the material forming the supporting board. The dielectric fluid may also have a higher thermal conductivity than air or the material forming the supporting board. As such, the dielectric fluid may allow heat to transfer away from the high-power density package at a greater rate than conductive contact with the supporting board or the air alone. The dielectric fluid may be circulated such that cooled dielectric fluid may be provided via the inlet, while hot dielectric fluid may be removed by the outlet. The dielectric fluid may circulate in either a closed loop where the dielectric fluid is fully recycled through a cooling loop or an open loop system where the dielectric fluid is replenished rather than recirculates, or a combination thereof. For example, in a combination of a closed loop and an open loop, the dielectric fluid may normally flow within a closed loop system and be recycled, but over time a portion may escape, so that additional dielectric fluid may be added to what is otherwise a closed loop system. The dielectric fluid may transfer from the cooling structure to one or more cooling devices, the cooling devices taking any suitable form, such as heat exchangers, thermoelectric coolers, radiative fins, etc. and combinations thereof. Such a listing of elements is not intended to be exhaustive, and in other embodiments, any known type of cooling device may be used. One or more pumps may be used to circulate the dielectric fluid between one or more cooling devices and one or more cooling structures.

Additionally, as heat is transferred from the high-power density package to the dielectric fluid, in a multi-phase dielectric the liquid phase may heat up until reaching the boiling point. Upon the liquid phase being heated to the boiling point of the multi-phase dielectric fluid, the liquid phase will reach a temperature plateau, as additional heat added to the liquid phase from the high-power density package may be consumed by the latent heat of the phase change of the multi-phase dielectric fluid from liquid phase to vapor phase. The dielectric fluid may be provided to the cooling structure in the liquid phase at the inlet and be removed at the outlet in the liquid phase, the vapor phase, or a combination thereof. As used herein, a 'temperature plateau' refers to a region where, during a phase change, the temperature remains substantially constant despite continued heat input because the added heat is consumed as latent heat.

The cooling structure may allow the dielectric fluid to transfer heat to the surrounding environment. The cooling structure may be made of a thermally conductive material such as a metal like copper, various alloys of steel, gold, silver and aluminum, as well as other thermally conductive materials such as boron arsenide, diamond, ceramics like aluminum nitride or silicon nitride, or any other suitable material, as well as combinations thereof . The cooling structure may directly conduct heat to air surrounding the cooling structure. The cooling structure will have a larger surface area than the high-power density package, thus may allow a greater transfer of heat from the high-power density package compared to direct heat transfer from the high-power density package.. The surfaces of the cooling structure may each function as a heat spreader, transferring heat produced within the high-power density package to the cooling structure surfaces where the increased surface area may transfer heat away to a surrounding environment quicker than the rate at which heat is generated in the high-power density package..

In addition, the heat transfer may be further increased by mounting additional cooling structures on surfaces of the cooling structure. For example, one or more of thermoelectric cooling plates using the Peltier effect, liquid cooling plates, heat exchangers, heat sinks, radiative fins, fans, or any other suitable cooling structure, may be formed on one or more exterior surfaces of the cooling structure. In some embodiments, the cooling structure may also be submerged within an additional cooling bath, for example, an open immersion bath that additional packages and components may share. In further embodiments, multiple cooling structures may be in a nesting configuration where multiple packages, each with an individual cooling structure, are within a larger immersion cooling bath, which may in turn be within an even larger immersion cooling bath.

The immersion cooling structure using a dielectric fluid may provide low energy cooling for high-density packaging while maintaining efficient heat transfer. The dielectric fluid may transfer heat from the high-power density package to the surface of the cooling structure, where an increased surface area may reduce the heat flux of the cooling structure compared to the high-power density package. Furthermore, the dielectric fluid may have an increased thermal conductivity compared to the supporting board or components the high-power density package may contact, providing thermal pathway for heat to transfer to the dielectric fluid and away from the board. In addition, the dielectric fluid may have a higher heat capacity than the supporting board or components the high-power density package is in contact with, such that heat from the high-power density package is transferred into the dielectric fluid at a higher rate due to the increased heat capacity of the dielectric fluid acting as a thermal sink. The heat capacity may be even further increased when the dielectric fluid has multiple phases within the operating zone, as enthalpy of vaporization may further increase the relative heat capacity of the dielectric fluid. As such, heat may be more quickly transferred from the individual packages to the cooling structures while providing a thermal sink where additional thermal energy is consumed by phase transitions, keeping the high-power density packages at the boiling temperature of the dielectric fluid. Additionally, by providing a cooling cycle to individual packages, the amount of dielectric fluid may be minimized, allowing for more expensive but effective coolants to be used. Furthermore, the package level cooling may be combined with additional cooling methods to further cool at the board, computer, rack and datacenter level scale. As a result, the amount of energy required to cool the high-power density package may be low. As such, the power usage efficiency or PUE of data center using high-power density packages within cooling structures disclosed herein may be low, near 1.0, such as between 1.03 and 1.02 for a single phase of dielectric fluid, or 1.01 for a two-phase dielectric fluid.

The cooling structures may be partially assembled with a top and side surfaces first joined together, such as via welding or mechanical fasteners. The high-power density packages may be separately assembled from individual components including integrated circuits. The high-power density packages are mounted on the bottom surfaces of the cooling structures, either directly or on a supporter. The top, side, and bottom sides of the cooling structures are then assembled together. The assembled cooling structures may then be mounted to connectors on the supporting board prior to filling the cooling structures with the dielectric fluid.

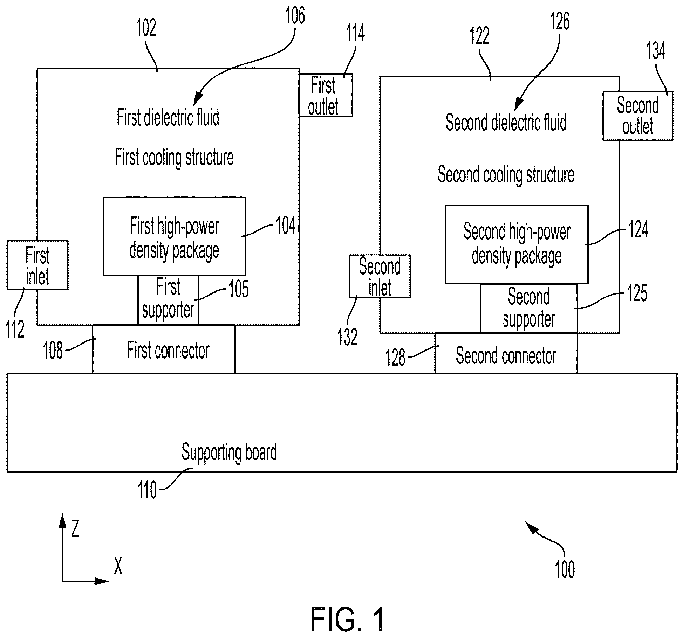

FIG. 1 depicts a cross-sectional view of an example embodiment of a first cooling architecture 100. One or more cooling structures, including a first cooling structure 102 and a second cooling structure 122 may be mounted on a supporting board 110. The supporting board 110 may take the form of a PCB, an interposer, a substrate, or take the form of a card such as a graphics card. The supporting board 110 may form a portion of a larger computer, which may in turn be incorporated into additional structures such as a server, server rack and data center. The first cooling structure 102 may contain a first high-power density package 104 and the second cooling structure 122 may contain a second high-power density package 124. The first high-power density package 104 and the second high-power density package 124 may include one or more compute devices as well as supporting circuitry, and may take the form of a chiplet, individual IC chips such as CPUs, GPUs, NPUs, and advanced packages such as HBM, as well as three-dimensional structures such device stacks and vertically stacked DRAM (VSDRAM). As used herein, a device stack or stack of devices may refer to a combination of memory and supporting circuit architecture, for example, chiplets and dies containing individual memory elements, supporting processing units, input output (I/O) circuitry, and other forms of integrated chips. As used herein, a chiplet may refer to an integrated circuit having a well-defined functionality, such as a microprocessor, a memory device, or other computational function; with a chiplet enabling a modular design with multiple chiplets able to be combined with a larger package, sharing a substrate or interposer to form a larger device. A core may refer to a single unit of a multicore device where multiple devices form a larger device, with each device able to function independently to enable multiple streams of operations. In some embodiments, a core may take the form of a chiplet, or a chiplet may take the form of a core. However, in other embodiments, a chiplet may take the form of any other suitable integrated circuit. As used herein, high bandwidth memory, or HBM, may refer to a chip structure including one or more HBM modules. In some embodiments, the HBM may be manufactured by an advanced silicon node process.

The first cooling structure 102 may contain a first dielectric fluid 106 and the second cooling structure 122 may contain a second dielectric fluid 126. The first dielectric fluid 106 and the second dielectric fluid 126 may have a low relative permittivity or dielectric constant, and thus function as an electrically non-conductive material, while having sufficient heat capacity to provide good thermal conductivity. Example dielectric fluids may include mineral oils, synthetic esters, silicone fluids, fluorinated liquids, hydrocarbon oils, as well as any other suitable fluid as this list is not intended to be exhaustive. In addition, the first dielectric fluid 106 and the second dielectric fluid 126 may be multi-phase dielectric fluids, including both a liquid phase and a vapor phase, with both phases functioning as dielectric materials providing electrical non-conductance and thermal conductivity. The first high-power density package 104 may be immersed in the first dielectric fluid 106 while the second high-power density package 124 may be immersed in the second dielectric fluid 126.

The first high-power density package 104 may be mounted on a first supporter 105, while the second high-power density package 124 may be mounted on a second supporter 125. The first supporter 105 and the second supporter 125 may take the form of a physically supportive structure allowing dielectric fluids to contact at least a portion of the first high-power density package 104 or the second high-power density package 124 and provide a physical connection to a corresponding connector on the supporting board 110. The first supporter 105 and the second supporter 125 also may contain one or more connections to allow the supporting board 110 to couple power and communications signals to the first high-power density package 104 or the second high-power density package 124. The first supporter 105 and the second supporter 125 may be configured in a variety of ways, and may be a solid shape such as a cube, structure or prism mounted directly to the bottom of the first cooling structure 102 or the second cooling structure 122, as well as may be formed from one or more separate elements, such as legs. In some embodiments, the first supporter 105 and the second supporter 125 may allow the first dielectric fluid 106 or the second dielectric fluid 126 to travel between the high-power density packages and the bottom of the cooling structures, while in others, the first supporter 105 and the second supporter 125 may be sized such that the space between the high-power density packages and the bottom of the cooling structures may be occupied.

The first supporter 105 may couple directly to a first connector 108 and the second supporter 125 may couple directly to a second connector 128. The first connector 108 and the second connector 128 may provide a connection for power and communications signals between the supporting board 110 and the first high-power density package 104 or the second high-power density package 124, which may be routed via the first supporter 105 or the second supporter 125. The first connector 108 and the second connector 128 may take many forms, including a redistribution layer (RDL) which may include one or more individual layers including one or more electrically conductive materials such as a series of pads, bumps, vias, through-vias, traces, and other forms of connection for redistributing signals across the layer, and may allow for signals to travel both laterally and vertically between the first high-power density package 104 or the second high-power density package 124 and the supporting board 110. In some embodiments, the first connector 108 and the second connector 128 may form a portion of the bottom of the first cooling structure 102 or the second cooling structure 122, while in other embodiments, the first supporter 105 or the second supporter 125 may extend through a portion of the first cooling structure 102 or the second cooling structure 122 to couple to the first connector 108 and the second connector 128.

The first cooling structure 102 and the second cooling structure 122 may take the form of a structure, prism, or similar shapes including a top, a bottom and sidewalls extending between. In the example embodiments discussed herein, there may be four sidewalls, but in some embodiments, the number of sidewalls may be larger or smaller, based on the desired geometry. The first cooling structure 102 and the second cooling structure 122 may be formed from a material with good thermal conductivity such as a metal like copper, various alloys of steel, gold, silver and aluminum, as well as other thermally conductive materials such as boron arsenide, diamond, ceramics like aluminum nitride or silicon nitride, or any other suitable material, as well as combinations thereof. The surfaces of the first cooling structure 102 and the second cooling structure 122 may each function as a heat spreader, spreading heat from the first dielectric fluid 106 or the second dielectric fluid 126 to the environment or a cooling device coupled to the first cooling structure 102 and the second cooling structure 122.

The first cooling structure 102 and the second cooling structure 122 may have heat produced by the first high-power density package 104 or the second high-power density package 124 absorbed by the first dielectric fluid 106 or the second dielectric fluid 126. As the first dielectric fluid 106 and the second dielectric fluid 126 may be chosen to have good thermal conductivity, heat may be efficiently transferred to the first dielectric fluid 106 or the second dielectric fluid 126 from the first high-power density package 104 or the second high-power density package 124.

Furthermore, the first cooling structure 102 and the second cooling structure 122 may have a larger surface area than the first high-power density package 104 or the second high-power density package 124 as the first cooling structure 102 or the second cooling structure 122 contain the first high-power density package 104 or the second high-power density package 124 within along with the additional components such as the first dielectric fluid 106 or the second dielectric fluid 126. The larger surface area may allow the first cooling structure 102 and the second cooling structure 122 to transfer heat to the environment at a greater rate than the first high-power density package 104 or the second high-power density package 124 may transfer heat to the first dielectric fluid 106 or the second dielectric fluid 126.

Additionally, the first dielectric fluid 106 circulated through the first cooling structure 102, and the second dielectric fluid 126 may be circulated through the second cooling structure 122. The first cooling structure 102 may have a first inlet 112 where the first dielectric fluid 106 may enter and a first outlet 114 where the first dielectric fluid 106 may exit. Similarly, the second cooling structure 122 may have a second inlet 132 for the second dielectric fluid 126 to enter and a second outlet 134 for the second dielectric fluid 126 to exit. The first dielectric fluid 106 or the second dielectric fluid 126 may be circulated such that cool dielectric fluid may be provided to the first inlet 112 or the second inlet 132, while heated dielectric fluid may leave via the first outlet 114 or the second outlet 134. The first dielectric fluid 106 and the second dielectric fluid 126 may be circulated in a closed loop, an open loop, or a combination thereof such as a closed loop which may allow additional dielectric fluid to be added. The first dielectric fluid 106 and the second dielectric fluid 126 may be circulated by either active means, such as a pump, or passive means, such as using pressure. The first dielectric fluid 106 and the second dielectric fluid 126 may be circulated to one or more cooling devices, such as evaporators, heat exchangers, thermoelectric coolers, condensers, radiator fans, or any other suitable cooling device.

In addition, while the examples herein show a first cooling structure 102 and a second cooling structure 122, in other embodiments, the number of cooling structures may be 1, 2, 4, 6, 8, 10, 16, 32, 64, or any other suitable number of cooling structures on a supporting board 110. Each cooling structure may have its own respective high-power density package, as well as dielectric fluids, supporters, connectors, cooling loops, etc.

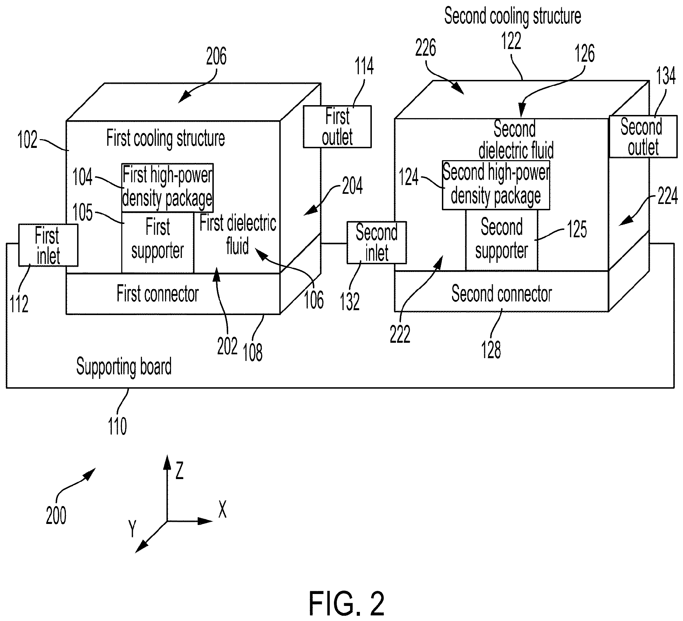

FIG. 2 depicts a perspective view of a second cooling architecture 200, the second cooling architecture 200 differing from the first cooling architecture 100 of FIG. 1 by providing a three-dimensional view including the sidewalls. The second cooling architecture 200 shows three of six visible sides of the first cooling structure 102 and the second cooling structure 122. The first cooling structure 102 has a first front side 202, a first side wall 204, and a first top side 206 depicted within FIG. 2. The second cooling structure 122 has a second front side 222, a second side wall 224, and a second top side 226 depicted within FIG. 2. Both the first cooling structure 102 and the second cooling structure 122 may have additional sides, including a back side, bottom side, and an additional side wall not visible in FIG 2. As discussed above, the first cooling structure 102 and the second cooling structure 122 may have a larger surface area than the first high-power density package 104 or the second high-power density package 124 as the first cooling structure 102 or the second cooling structure 122 contain the first high-power density package 104 or the second high-power density package 124 within along with the additional components such as the first dielectric fluid 106 or the second dielectric fluid 126. The larger surface area may allow the first cooling structure 102 and the second cooling structure 122 to transfer heat to the environment at a greater rate than the first high-power density package 104 or the second high-power density package 124 may transfer heat to the first dielectric fluid 106 or the second dielectric fluid 126, and via the first dielectric fluid 106 or the second dielectric fluid 126, the heat may be transferred to the sides of the first cooling structure 102 and the second cooling structure 122 where the top and side walls may each provide a surface to allow heat to be transferred to the surrounding environment.

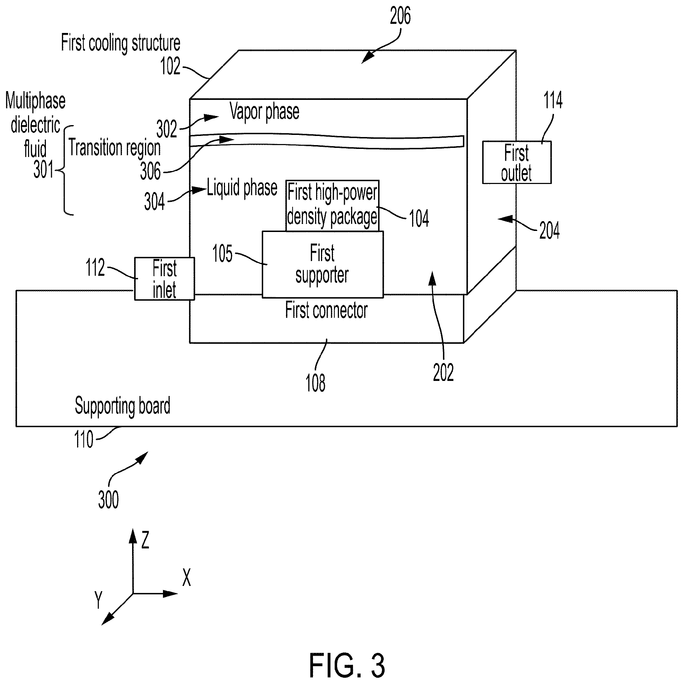

FIG. 3 depicts a perspective view of a third cooling architecture 300 differing from the first cooling architecture 100 of FIG. 1 by providing an example of a multi-phase dielectric fluid 301. In the example of FIG. 3, only the first cooling structure 102 is shown, but the second cooling structure 122 may be arranged similarly to the first cooling structure 102. The multi-phase dielectric fluid 301 may include a vapor phase 302, a liquid phase 304, and a transition region 306 where the vapor phase 302 may transition to the liquid phase 304 or the liquid phase 304 may transition to the vapor phase 302. In some embodiments, the transition region 306 may form the surface of the liquid phase 304. As heat may be transferred from the first high-power density package 104 to the liquid phase 304, the liquid phase 304 may heat up until reaching the boiling point of the multi-phase dielectric fluid 301. Upon the liquid phase 304 being heated to the boiling point of the multi-phase dielectric fluid 301, the liquid phase 304 will reach a temperature plateau, as additional heat added to the liquid phase 304 from the first high-power density package 104 may be consumed by the latent heat of the phase change of the multi-phase dielectric fluid 301 from liquid phase 304 to vapor phase 302. As such, the multi-phase dielectric fluid 301 may be chosen such that the boiling point of the multi-phase dielectric fluid 301 may be within the operating range of the first high-power density package 104.

The multi-phase dielectric fluid 301 may be provided to the first cooling structure 102 via the first inlet 112 in the liquid phase 304, while the first outlet 114 may output the multi-phase dielectric fluid 301 in the vapor phase 302, the liquid phase 304, or a combination thereof. In some embodiments, the first outlet 114 may be arranged such that only vapor phase 302 or only liquid phase 304 may exit as part of circulating the multi-phase dielectric fluid 301. For example, the first outlet 114 may be configured to allow only the vapor phase 302 to exit as part of a passive cooling system, where the vapor phase 302 may be collected into a condenser before being returned to the first inlet 112 back in the liquid phase 304. Alternatively, the first outlet 114 may be configured to allow liquid phase 304 to exit using an active means such as a pump to circulate the multi-phase dielectric fluid 301 to a cooling device.

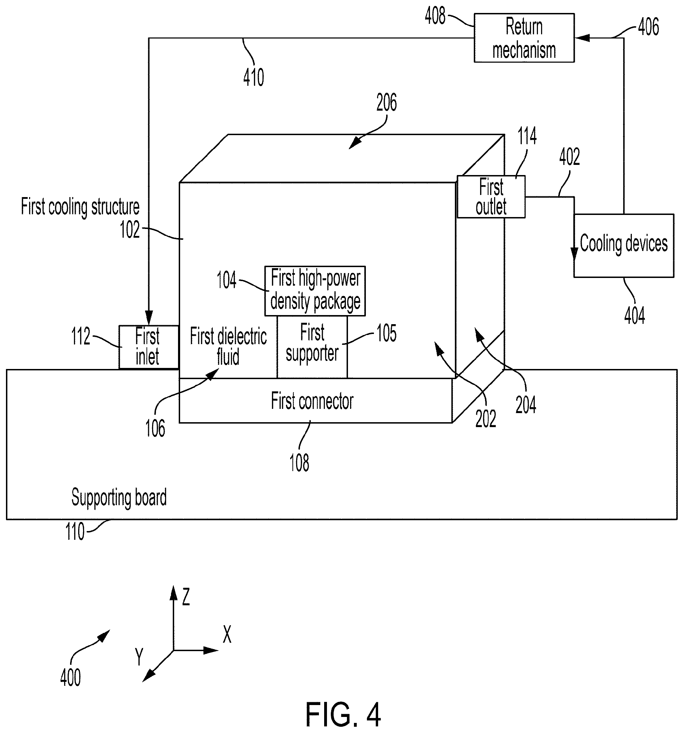

FIG. 4 depicts a perspective view of a fourth cooling architecture 400, differing from the first cooling architecture 100 by providing additional details on the circulation of the first dielectric fluid 106. In the example of FIG. 4, only the first cooling structure 102 is shown, but the second cooling structure 122 may be arranged similarly to the first cooling structure 102. The first dielectric fluid 106 may enter the first cooling structure 102 at the first inlet 112. The first dielectric fluid 106 may then be heated by the operation of the first high-power density package 104 within the first cooling structure 102 and exit the first cooling structure 102 via the first outlet 114. A first conduit 402 may extend from the first outlet 114 to one or more cooling devices 404. The one or more cooling devices 404 may take the form of any suitable cooling device, including evaporators, condensers, heat exchangers, radiative fins, cooling plates, thermoelectric coolers, etc. The one or more cooling devices 404 may cool the first dielectric fluid 106, which may include condensing vapor from a multi-phase dielectric fluid back into liquid. A second conduit 406 may extend from the one or more cooling devices 404 to return mechanism 408. The return mechanism 408 may take the form of one or more mechanisms provided to return the first dielectric fluid 106 back to the cooling structure. In some embodiments, the return mechanism 408 may include a pump, a storage tank, a pressurized chamber, or some combination thereof. In some embodiments, the return mechanism 408 may be a passive mechanism, and, for example, may be combined with one or more cooling devices 404, for example, a gravity return from a condenser. The first dielectric fluid 106 may then be routed via a third conduit 410 from the return mechanism 408 back to the first cooling structure 102 via the first inlet 112.

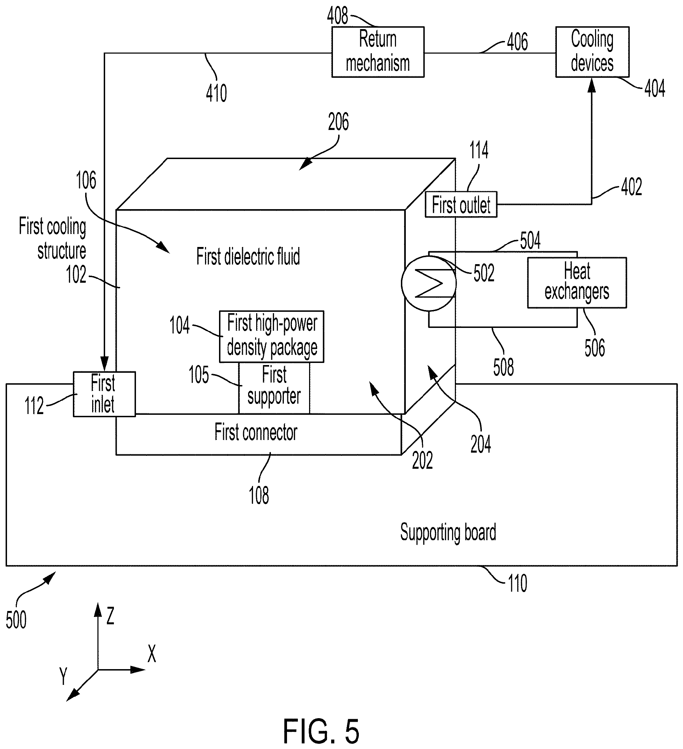

FIG. 5 depicts an example of a fifth cooling architecture 500, differing from the fourth cooling architecture 400 by adding a first cooling device 502 to the first cooling structure 102. The first cooling device 502 may take the form of any suitable active cooling device, such as a thermoelectric cooler, a cold plate, a heat exchanger, a fan, as well as passive cooling devices such as radiative fins, as well as combinations thereof. In some embodiments, the first cooling device 502 may be mounted on the first side wall 204 of the first cooling structure 102, while in other embodiments, the first cooling device 502 may be mounted on the first top side 206, the first front side 202 or any other surface. In some embodiments, the first cooling device 502 may include multiple cooling devices which may be mounted on the top, bottom or sidewalls of the first cooling structure 102. The first cooling device 502 may transfer heat from the surface of the first cooling structure 102 without directly contacting the first dielectric fluid 106. The first cooling device 502 may in turn be coupled to additional cooling devices, for example, when the first cooling device 502 takes the form of cold plates, the cold plates may circulate fluid which may be pumped to additional heat exchangers 506 to cool the fluid and include a cold conduit 504 feeding the first cooling device 502 and a hot conduit 508 to transfer hot fluid away from the first cooling device 502. The first cooling device 502 may provide additional cooling to the passive heat exchange between the first cooling structure 102 and the ambient environment, as well as to the cooling provided by the one or more cooling devices 404. The additional cooling may help maintain the first dielectric fluid 106 in a desired temperature range, and thus the first high-power density package 104 within a desired operating temperature range.

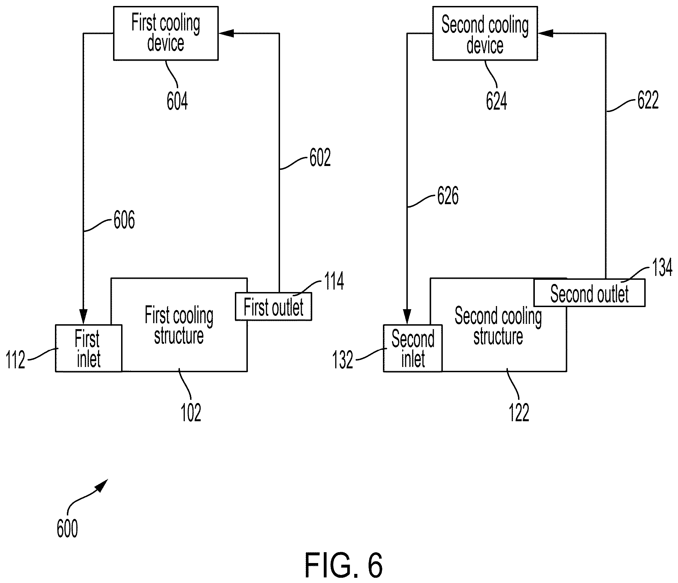

FIG. 6 depicts a sixth cooling architecture 600, differing from the first cooling architecture 100 by providing additional details on the circulation of the first dielectric fluid 106 and the second dielectric fluid 126. In the example of the sixth cooling architecture 600, the first cooling structure 102 and the second cooling structure 122 may each be fluidically coupled to a separate cooling system. The first dielectric fluid 106 of the first cooling structure 102 may be fluidically coupled via a first hot conduit 602 from the first outlet 114 to a first cooling device 604, and the first dielectric fluid 106 may be returned back to the first cooling structure 102 via a first cool conduit 606 fluidically coupled to the first inlet 112. As used herein, "fluidically coupled" may refer to being configured such that a fluid flows from one component to another component. Similarly, the second dielectric fluid 126 of the second cooling structure 122 may be fluidically coupled via a second hot conduit 622 from the second outlet 134 to a second cooling device 624, and the second dielectric fluid 126 may be returned back to the second cooling structure 122 via a second cool conduit 626 fluidically coupled to the second inlet 132. In the example of FIG. 6, each cooling structure may have a separate cooling loop, which may allow for the maintenance to be performed on a single cooling loop without shutting down the entire system. Furthermore, as each cooling structure may have its own separate cooling loop, the dielectric fluid may differ between each cooling structure. For example, the dielectric fluid for each cooling structure may be chosen in part on the optimal temperature range for the high-power density packages within. Additionally, by separating each cooling structure into a separate loop, the temperature of the dielectric fluid may be more easily controlled.

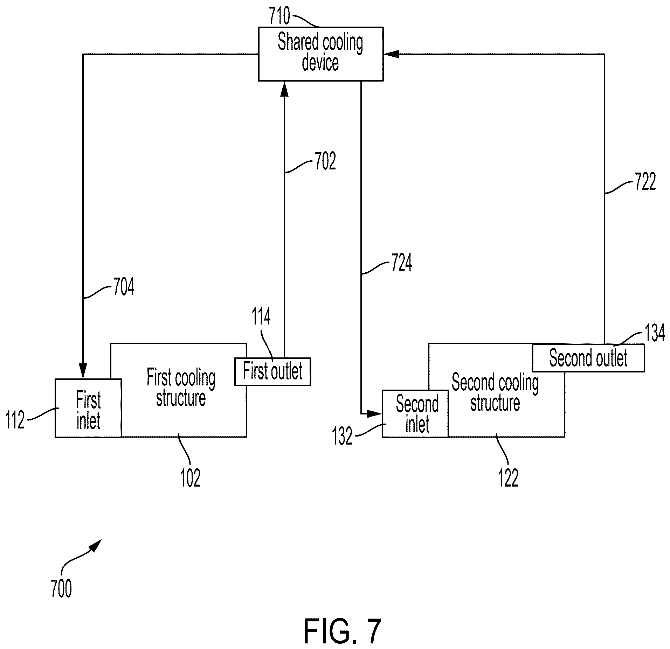

FIG. 7 depicts a seventh cooling architecture 700, differing from the sixth cooling architecture 600 by having a shared cooling device 710 shared by the first cooling structure 102 and the second cooling structure 122 in parallel. In the example of FIG. 7, the first cooling structure 102 forms a cooling loop where the first dielectric fluid 106, after being heated, may be output from the first outlet 114 and, via a first hot conduit 702, may travel to the shared cooling device 710 before the first dielectric fluid 106 returns via a first cool conduit 704 to the first cooling structure 102 via the first inlet 112. In the same manner, the second cooling structure 122 may form a cooling loop where the second dielectric fluid 126, after being heated, may be output from the second outlet 134, and via a second hot conduit 722, and may travel to the shared cooling device 710 before the second dielectric fluid 126 may return via a second cool conduit 724 to the second cooling structure 122 via the second inlet 132. In the example of FIG. 7, the first dielectric fluid 106 and the second dielectric fluid 126 may be both cooled at the shared cooling device 710, and may have the same composition, such that the cooling fluid may be shared by both the first cooling structure 102 and the second cooling structure 122. This configuration may simplify the cooling requirements by using a single cooling device for the dielectric fluid, while the parallel access to the shared cooling device 710 may provide cool dielectric fluid at the same temperature to both the first cooling structure 102 and the second cooling structure 122.

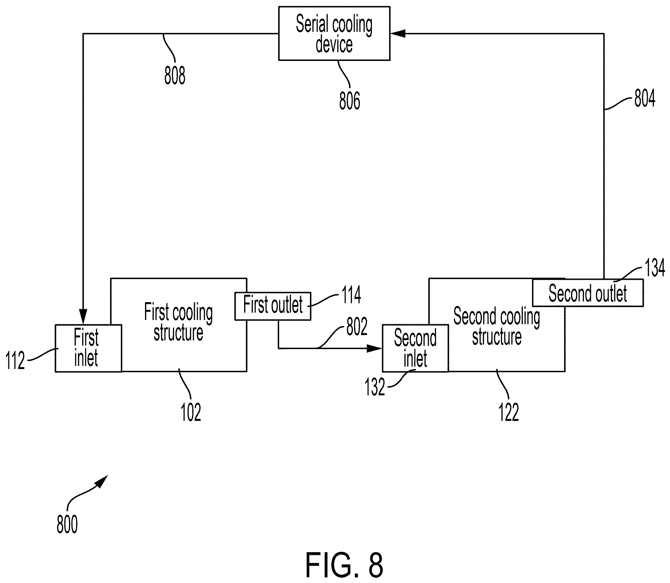

FIG. 8 depicts an eighth cooling architecture 800, differing from the seventh cooling architecture 700 by providing a serial cooling device 806 shared by the first cooling structure 102 and the second cooling structure 122 in series. In the example of FIG. 8, the first outlet 114 from the first cooling structure 102 may be fluidically coupled via a first serial conduit 802 to the second inlet 132 of the second cooling structure 122. The second cooling structure 122 then may output via the second outlet 134 to a second serial conduit 804 to the serial cooling device 806. The loop may be completed by fluidically coupling the serial cooling device 806 via a third serial conduit 808 to the first inlet 112 of the first cooling structure 102. In the example of FIG. 8, the first dielectric fluid 106 and the second dielectric fluid 126 may be the same dielectric fluid and be shared between each cooling structure. The configuration of the eighth cooling architecture 800 may be useful if the operating ranges of the first high-power density package 104 and the second high-power density package 124 differ, such that the hot outlet from the first cooling structure 102 remains at an acceptable temperature to function as the cool inlet for the second cooling structure 122. Alternatively, the first cooling structure 102 may serve to heat the shared dielectric fluid, while the second cooling structure 122 provides additional heat such that the shared dielectric fluid boils, and the vapor from the second cooling structure 122 may be condensed, allowing for a passive circulation of dielectric fluids.

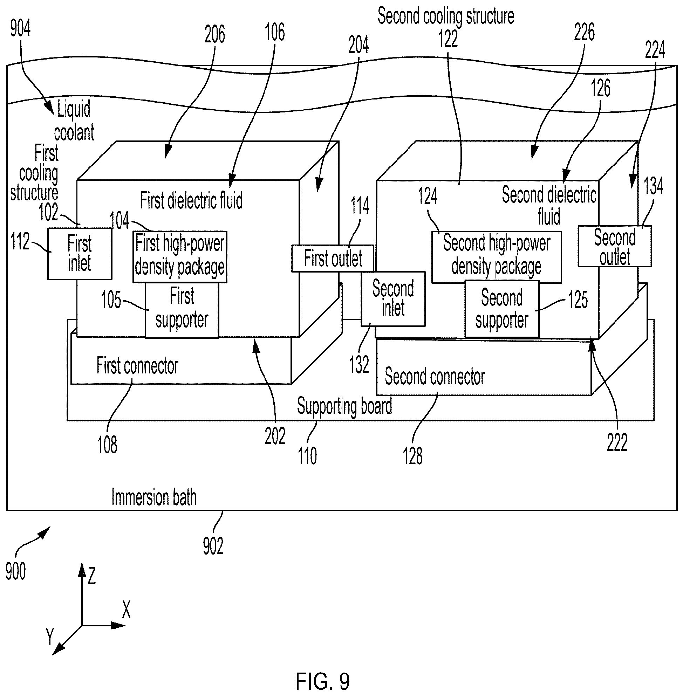

FIG. 9 depicts a ninth cooling architecture 900, differing from the first cooling architecture 100 by placing the first cooling architecture 100 including the supporting board 110 and both the first cooling structure 102 and the second cooling structure 122 into an immersion bath 902. The immersion bath 902 may contain a liquid coolant 904, which may be a liquid dielectric, such as the first dielectric fluid 106 or the second dielectric fluid 126. In the example of FIG. 1, both the first cooling structure 102 and the second cooling structure 122 are shown as submerged with the liquid coolant 904 including the top surface. As such, heat conducted by the first high-power density package 104 or the second high-power density package 124 to the first dielectric fluid 106 or the second dielectric fluid 126 may be conducted via the top and sides of the first cooling structure 102 or the second cooling structure 122 to the liquid coolant 904. However, the difference in sizes between the immersion bath 902 and the first cooling structure 102 or the second cooling structure 122, as well as the nature of the first cooling structure 102 and the second cooling structure 122 being sealed may allow different materials to be used. The first dielectric fluid 106 and the second dielectric fluid 126, as being sealed within a small volume, may have their material chosen based on the boiling point of the fluid to match the first high-power density package 104 or the second high-power density package 124. The relatively small volume allows for a more expensive but more efficient fluid to be used within the first cooling structure 102 or the second cooling structure 122 as they may be closed cycles and sealed. In addition, the smaller and sealed volume allows for dielectric materials such as fluorinated liquids which may have corrosive or reactive properties which may be undesirable for larger immersion baths, which may require more servicing. In addition, the first cooling structure 102 and the second cooling structure 122 may resolve potential issues from placing high-power density packages directly into an immersion bath, as the first cooling structure 102 and the second cooling structure 122 may transfer heat in a closed cycle away from the first high-power density package 104 or the second high-power density package 124. Placing a high-power density package directly into a larger immersion bath may risk the heat from a high-power density package may not be transferred sufficiently fast enough to keep the high-power density package operating due to the smaller surface area of the high-power density package in comparison to the first cooling structure 102 or the second cooling structure 122.

In the example of FIG. 9, the immersion bath 902 is shown as an open bath, but in other embodiments, the immersion bath 902 may be a closed bath. Additionally, in the example of FIG. 9, the immersion bath 902 is shown only holding the supporting board 110 and its components, but in other embodiments, the immersion bath 902 may contain additional portions of a computing environment, such as an entire computer, server, server rack, and/or datacenter within the same immersion bath. In some embodiments, the immersion baths may be nested. For example, one or more high-power density packages may be mounted in individual cooling structures on the supporting board 110. The supporting board 110 may then be placed within a larger board immersion cooling structure containing the board and individual cooling structures. Multiple boards, each within an individual board immersion cooling structure, may be placed within a server cooling structure intended to cool an entire server. Multiple server cooling structures may be then placed within a server rack cooling structure. Finally, a datacenter may have an open immersion cooling bath where multiple server racks may be cooled, each server rack including multiple cooling structures for server racks.

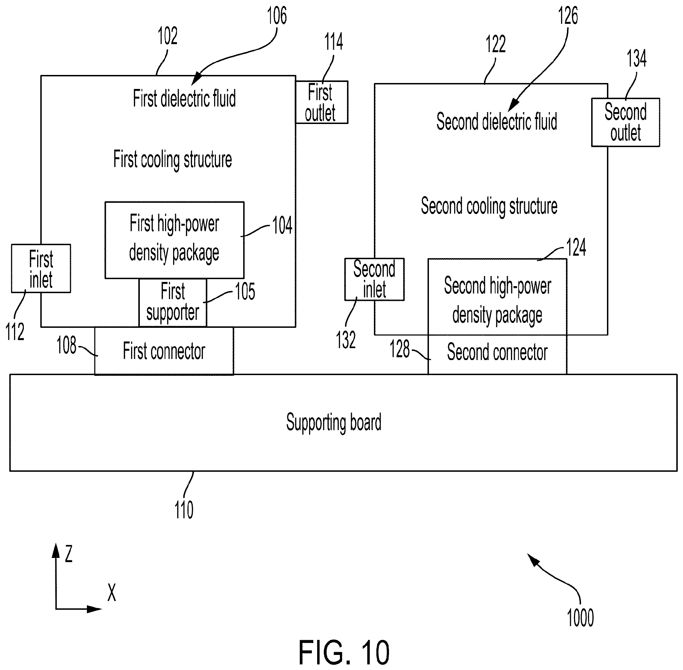

FIG. 10 depicts an example of a tenth cooling architecture 1000, differing from the first cooling architecture 100 by presenting a version of the second cooling structure 122 without the second supporter 125. While the first cooling architecture 100 provides each cooling structure shown with an individual supporter to couple the high-power density package to the supporting board 110, in some embodiments, such as FIG. 10, the supporters may be omitted, such that the second high-power density package 124 may directly rest on a bottom surface of the second cooling structure 122.

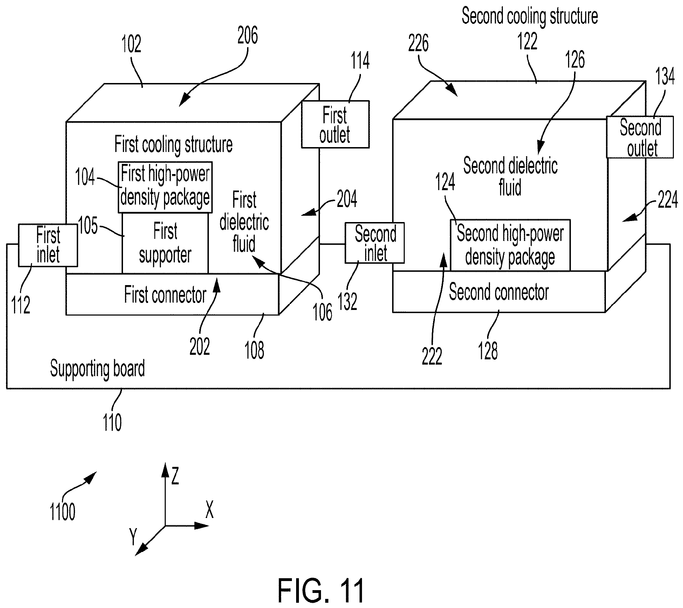

FIG. 11 depicts an example of an eleventh cooling architecture 1100, differing from the second cooling architecture 200 in the similar way as the tenth cooling architecture 1000 differs from the first cooling architecture 100 by presenting a version of the second cooling structure 122 without the second supporter 125. While the second cooling architecture 200 provides each cooling structure shown with an individual supporter to couple the high-power density package to the supporting board 110, in some embodiments, such as FIG. 11, the supporters may be omitted, such that the second high-power density package 124 may directly rest on a bottom surface of the second cooling structure 122.

In some embodiments, supporters may be completely omitted such that all high-power density packages may rest on the bottom surfaces of their respective cooling structures, while in other embodiments, a mix of direct resting and supporter resting high-power density packages may be used. The high-power density packages may, in some embodiments, be coupled directly via the bottom of their cooling structure to the supporting board 110 to provide a shorter direct connection to reduce latency and increase throughput of signals to and from the high-power density packages, while in other embodiments a supporter may be used, for example, to provide additional surface area to cool the high-power density packages.

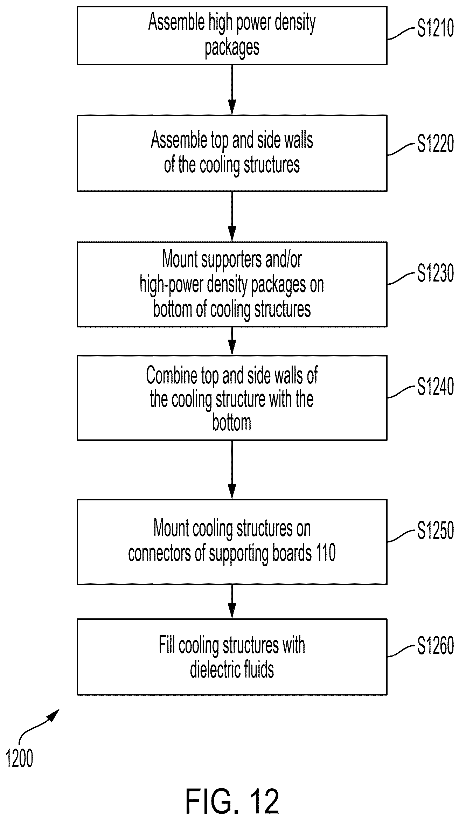

FIG. 12 depicts an example embodiment of a process 1200 for assembling a cooling architecture such as the first cooling architecture 100 or any other cooling architectures shown in FIGS. 1-11.

In the process 1200 at S1210, the high-power density packages, including the first high-power density package 104 and the second high-power density package 124 are assembled. The high-power density packages may be assembled in a front end of line (FEOL) or back end of line (BEOL) facility, as well as a combination thereof. The high-power density packages may be assembled from one or more integrated circuits including processing units, memory units, logic circuity, power conditioning circuitry, and may include CPUs, XPUs, GPUs, NPUs, advanced packages such as HBM, as well as three-dimensional structures such device stacks, VSDRAM or any other suitable package. In some embodiments, the high-power density package may include photonic devices such as planar lightwave circuits (PLCs) either alone or in combination with other forms of integrated circuits. The high-power density packages may be mounted on one or more shared substrates such as silicon, silicon on insulator, glass, germanium, as well as organic substrates. In some embodiments, the high-power density packages may be mounted on one or more interposers. The devices in the high-power density packages may be mounted using various techniques including a conductive connection such as pads, bumps, microbumps, pillars, balls, ball grids, microball arrays, and other forms such as controlled-collapse chip connection (C4) bumps, or any other suitable method alone or in combination. As used herein, a C4 bump refers to a form of solder bumps placed on pads on a top surface of a substrate prior to flipping the substrate to form a flip-chip. The mounting method may further include a dielectric material, which may include a material such as an adhesive, resin, or elastomer which may form a connection in addition to a conductive connection, and may be provided using an underfill method. In some embodiments, the devices of the high-power density packages may be further secured using an epoxy molding compound (EMC) or other suitable techniques to encapsulate the high-power density packages.

In the process 1200 at S1220, the cooling structures such as the first cooling structure 102 and the second cooling structure 122 have the top and side walls assembled. The top and side walls of the cooling structures may be assembled using various techniques including mechanical connections, molding, welding, brazing, soldering, additive manufacturing, spinning, weaving, or any other suitable method with the techniques varying on the materials of the cooling structures. In some embodiments, sealing elements such as gaskets, washers, etc. may be used to provide a tighter fit between each component.

In the process 1200 at S1230, supporters such as the first supporter 105 or the second supporter 125 may be mounted on bottom surface of the cooling structures. In some embodiments, the high-power density packages may be mounted on a supporter either prior to or after the supporters are mounted on the bottom surface of the cooling structures. In some embodiments, the supporters may be omitted and the high-power density packages may be directly mounted on the bottom of the cooling structure. The bottom of the cooling structures may include one or more holes, vias, slots, or other pathways to allow power and communications signals to travel to the high-power density packages. In some embodiments, the supporter may directly contact the connectors on the supporting board 110 by extending through a portion of the bottom surface of the cooling structures. The supporters and high-power density packages may be mounted using various techniques including a conductive connection such as pads, bumps, microbumps, pillars, balls, ball grids, microball arrays, or any other suitable method and other forms such as C4 bumps, alone or in combination. The mounting method may further include a dielectric material, which may include a material such as an adhesive, resin, or elastomer which may form a connection in addition to a conductive connection and may be provided using an underfill method.

In the process 1200 at S1240, the top and side walls of the cooling structures are combined with the bottom surfaces to form a completed cooling structure. The top, side walls and bottom surfaces may be assembled using various techniques including mechanical connections, molding, welding, brazing, soldering, additive manufacturing, spinning, weaving, or any other suitable method with the techniques varying on the materials of the cooling structures. In some embodiments, sealing elements such as gaskets, washers, etc. may be used to provide a tighter fit between each component.

In the process 1200 at S1250, the cooling structures are mounted on the connectors of the supporting board 110, such as the first connector 108 or the second connector 128. In some embodiments, the high-power density packages may be directly coupled to the connectors while in other embodiments one or more intermediate structures such as the supporters may be between the high-power density packages and the connectors of the supporting board 110. The cooling structures and the high-power density packages along with any intermediate structures may be mounted to the connectors using various techniques including a conductive connection such as pads, bumps, microbumps, pillars, balls, ball grids, microball arrays, and other forms such as C4 bumps, or any other suitable method alone or in combination. The connecting method may further include a dielectric material, which may include a material such as an adhesive, resin, or elastomer which may form a connection in addition to a conductive connection and may be provided using an underfill method.

In the process 1200 at S1260, the cooling structures may be filled with the dielectric fluids such as the first dielectric fluid 106 or the second dielectric fluid 126. The dielectric fluids may be provided, for example, via a cooling loop as those described above, where an inlet and outlet are formed on the cooling structure. In other embodiments, the dielectric fluid may be provided directly via an inlet to the cooling structure. The dielectric fluid may be filled so as to fully immerse the high-power density packages within the fluid and may include sufficient dielectric fluid in the liquid phase such that the high-power density packages are fully immersed in liquid. In some embodiments, head space may remain above the high-power density packages such that vapor or gas may remain within the cooling structure. As used herein, the "head space" may refer to a space remaining above a liquid phase of the dielectric fluid within the cooling structure, in which vapor or gas remains. In other embodiments, the cooling structures may be filled to remove such a head space, with the cooling structures thus filled with the liquid phase of dielectric fluid.

While this specification may contain many specific implementation details, the implementation details should not be construed as limitations on the scope of any claimed subject matter but rather be construed as descriptions of features specific to particular embodiments. Certain features that are described in this specification in the context of separate embodiments may also be implemented in combination in a single embodiment. Conversely, various features that are described in the context of a single embodiment may also be implemented in multiple embodiments separately or in any suitable subcombination. Moreover, although features may be described above as acting in certain combinations and even initially claimed as such, one or more features from a claimed combination may in some cases be excised from the combination, and the claimed combination may be directed to a subcombination or variation of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing may be advantageous. Moreover, the separation of various system components in the embodiments described above should not be understood as requiring such separation in all embodiments, and it should be understood that the described program components and systems can generally be integrated together in a single software product or packaged into multiple software products.

Thus, particular embodiments of the subject matter have been described herein. Other embodiments are within the scope of the following claims. In some cases, the actions set forth in the claims may be performed in a different order and still achieve desirable results. Additionally, the processes depicted in the accompanying figures do not necessarily require the particular order shown, or sequential order, to achieve desirable results. In certain implementations, multitasking and parallel processing may be advantageous.

## Claims

1. A device comprising:
a supporting board (110);
a first cooling structure (102) on the supporting board (110), the first cooling structure (102) including a first high-power density package (104) immersed within a first dielectric fluid (106; 301), the first dielectric fluid (106; 301) thermally coupled to the first high-power density package (104); and
a first connector (108) on the supporting board (110), the first connector (108) arranged between the first cooling structure (102) and the supporting board (110), the first connector (108) communicatively coupling the first high-power density package (104) to the supporting board (110),
wherein the first dielectric fluid (106; 301) is separated from the first connector (108) by at least one surface of the first cooling structure (102).

2. The device of claim 1, wherein the first dielectric fluid (301) has a first liquid phase (304) and a first vapor phase (302) within the first cooling structure (102).

3. The device of claim 1 or 2, further comprising:
a second cooling structure (122) on the supporting board (110), the second cooling structure (122) including:
a second high-power density package (124) immersed within a second dielectric fluid (126), the second dielectric fluid (126) thermally coupled to the second high-power density package (124); and
a second connector (128) on the supporting board (110), the second connector (128) arranged between the second cooling structure (122) and the supporting board (110), the second connector (128) communicatively coupling the second high-power density package (124) to the supporting board (110),
wherein the second dielectric fluid (126) is separated from the second connector (128) by at least one surface of the second cooling structure (122).

4. The device of any one of claims 1 to 3, wherein the first high-power density package (104) includes at least one selected from the group consisting of a memory device and a processing device.

5. The device of any one of claims 1 to 4, wherein the first dielectric fluid (106; 301) circulates in a closed loop from the first cooling structure (102) to a first cooling device (404; 604; 710; 806), the first cooling device (404; 604; 710; 806) including one or more of a thermoelectric cooler, a cold plate, a heat exchanger, a radiative fin, or a heat sink.

6. The device of any one of claims 1 to 5, further comprising a first supporter (105), the first supporter (105) arranged between the first connector (108) and the first high-power density package (104), the first supporter (105) arranged between a surface of the first cooling structure (102) and the first high-power density package (104), and
wherein the first supporter (105) contacts the first dielectric fluid (106; 301).

7. The device of any one of claims 1 to 6, wherein at least one cooling device is mounted on an exterior surface of the first cooling structure (102), and
wherein the at least one cooling device includes one or more of a thermoelectric cooler, a cold plate, a heat exchanger, a radiative fin, and a heat sink.

8. A device comprising:
a supporting board (110);
a first cooling structure (102) on the supporting board (110), the first cooling structure (102) including:
a first high-power density package (104) immersed within a first dielectric fluid (106; 301), the first dielectric fluid (106; 301) thermally coupled to the first high-power density package (104);
a first connector (108) on the supporting board (110), the first connector (108) arranged between the first cooling structure (102) and the supporting board (110), the first connector (108) communicatively coupling the first high-power density package (104) to the supporting board (110); and
a first cooling loop, the first cooling loop circulating the first dielectric fluid (106; 301), the first cooling loop fluidically coupling a first cooling device (404; 604; 710; 806) to a first inlet (112) of the first cooling structure (102), and the first cooling loop fluidically coupling a first outlet (114) of the first cooling structure (102) to the first cooling device (404; 604; 710; 806).

9. The device of claim 8, wherein the first cooling device (404; 604; 710; 806) includes one or more of a thermoelectric cooler, a cold plate, a heat exchanger, a radiative fin, or a heat sink.

10. The device of claim 8 or 9, wherein at least one cooling device is mounted on an exterior surface of the first cooling structure (102), and
wherein the at least one cooling device includes one or more of a thermoelectric cooler, a cold plate, a heat exchanger, a radiative fin, or a heat sink.

11. The device of any one of claims 8 to 10, wherein the first high-power density package (104) includes at least one selected from the group consisting of a memory device and a processing device.

12. The device of any one of claims 8 to 11, further comprising:
a second cooling structure (122) on the supporting board (110), the second cooling structure (122) including:
a second high-power density package (124) immersed within a second dielectric fluid (126), the second dielectric fluid (126) thermally coupled to the second high-power density package (124);
a second connector (128) on the supporting board (110), the second connector (128) arranged between the second cooling structure (122) and the supporting board (110), the second connector (128) communicatively coupling the second high-power density package (124) to the supporting board (110); and
a second cooling loop, the second cooling loop circulating the second dielectric fluid (126), the second cooling loop fluidically coupling a second cooling device (624) to a second inlet (132) of the second cooling structure (122), and the second cooling loop fluidically coupling a second outlet (134) of the second cooling structure (122) to the second cooling device (624).

13. The device of any one of claims 8 to 12, further comprising a first supporter (105), the first supporter (105) arranged between the first connector (108) and the first high-power density package (104), the first supporter (105) arranged between a surface of the first cooling structure (102) and the first high-power density package (104), and
wherein the first supporter (105) contacts the first dielectric fluid (106; 301).

14. A system comprising:
a supporting board (110);
a first cooling structure (102) on the supporting board (110), the first cooling structure (102) including:
a first high-power density package (104) immersed within a first dielectric fluid (106; 301), the first dielectric fluid (106; 301) thermally coupled to the first high-power density package (104), the first high-power density package (104) communicatively coupled to the supporting board (110);
a second cooling structure (122) on the supporting board (110), the second cooling structure (122) including:
a second high-power density package (124) immersed within a second dielectric fluid (126), the second dielectric fluid (126) thermally coupled to the second high-power density package (124), the second high-power density package (124) communicatively coupled to the supporting board (110); and
a first cooling loop, the first cooling loop circulating the first dielectric fluid (106; 301), the first cooling loop fluidically coupling a first cooling device (604) to a first inlet (112) of the first cooling structure (102), and the first cooling loop fluidically coupling a first outlet (114) of the first cooling structure (102) to the first cooling device (102); and
a second cooling loop, the second cooling loop circulating the second dielectric fluid (126).

15. The system of claim 14, wherein the first high-power density package (104) includes at least one selected from the group consisting of a memory device and a processing device.
